# EUROPEAN PATENT SPECIFICATION

(11) **EP 3 682 468 B1**
(45) Date of publication and mention of the grant of the patent: **31.05.2023**
(21) Application number: 18871077.6
(22) Date of filing: 26.10.2018
(51) Int. Cl.: H01L 21/67, H01L 21/687, H01L 21/683

(54) **SUBSTRATE HANDLING APPARATUS FOR EXTREME WARPED WAFERS**
VORRICHTUNG ZUR HANDHABUNG VON SUBSTRATEN FÜR EXTREM GEKRÜMMTE WAFER
APPAREIL DE MANIPULATION DE SUBSTRAT POUR PLAQUETTES EXTRÊMEMENT DÉFORMÉES

(30) Priority: 27.10.2017 US 201762578251 P; 01.10.2018 US 201816148498
(43) Date of publication of application: 22.07.2020
(73) Proprietor: KLA - Tencor Corporation, Milpitas, California 95035 (US)
(72) Inventor: RAGHAVAN, Balajee, Simei 529945 (SG); YAKOVLEV, Andrey, 3473301 Haifa (IL)
(74) Representative: FRKelly
(86) International application number: PCT/US2018/057618
(87) International publication number: WO 2019/084347

(56) References cited:
- KR-A- 20060 108 086
- US-A1- 2015 076 849
- US-A1- 2015 086 316
- US-A1- 2015 287 626
- US-A1- 2015 332 950

## Description

### CROSS-REFERENCE TO RELATED APPLICATION

The present application refers to U.S. Provisional Application Serial Number 62/578,251, filed October 27, 2017, entitled END EFFECTOR FOR HANDLING DEVICE FOR EXTREME WARPED SILICON WAFERS, naming Balajee Raghavan and Andrey Yakovlev as inventors.

### TECHNICAL FIELD

The present invention generally relates to sample inspection, and, more particularly, to a substrate handling apparatus for handling warped substrates.

### BACKGROUND

Semiconductor sample inspection requires careful handling of the samples, such as silicon wafers. However, previous wafer handling methods may be unable to adequately handle wafers of various shapes and sizes. For example, previous handling approaches may be unable to handle warped wafers, such as warped 300mm wafers. Previous wafer handling methods may include the edge-contact method, the 3X vacuum suction cup method, and the gravity method. The edge-contact handling method may be unable to handle a range of sample substrate thicknesses, resulting in unstable handling. Similarly, the 3X vacuum suction cup method may be ineffective in handling various wafer shapes, including warped wafers. Lastly, under the gravity method, handling tools may be unable to move at high speeds, resulting in low throughput. Therefore, it would be desirable to provide a system and method that cure one or more of the shortfalls of the previous approaches identified above.

US2015/086316 discloses a pneumatic end effector apparatus, substrate transportation systems, and methods for transporting substrates.

### SUMMARY

A substrate handling apparatus is disclosed, as recited in claim 1.

A system for handling a substrate is disclosed, as recited in claim 9.

It is to be understood that both the foregoing general description and the following detailed description are exemplary and explanatory only and are not necessarily restrictive of the invention as claimed. The accompanying drawings, which are incorporated in and constitute a part of the specification, illustrate embodiments of the invention and together with the general description, serve to explain the principles of the invention.

### BRIEF DESCRIPTION OF THE DRAWINGS

The numerous advantages of the disclosure may be better understood by those skilled in the art by reference to the accompanying figures in which:
- FIG. 1A: illustrates a top view of a substrate handling apparatus, in accordance with one or more embodiments of the present disclosure;
- FIG. 1B: illustrates a bottom view substrate handling apparatus, in accordance with one or more embodiments of the present disclosure;
- FIG. 2: illustrates a top view of a substrate handling system, in accordance with one or more embodiments of the present disclosure;
- FIG. 3: illustrates a simplified schematic view of a substrate handling system, in accordance with one or more embodiments of the present disclosure; and
- FIG. 4: illustrates a flowchart of a method of handling a substrate, in accordance with one or more embodiments of the present disclosure.

### DETAILED DESCRIPTION

The present disclosure has been particularly shown and described with respect to certain embodiments and specific features thereof. The embodiments set forth herein are taken to be illustrative rather than limiting. It should be readily apparent to those of ordinary skill in the art that various changes and modifications in form and detail may be made without departing from the scope of the invention, which is defined by the appended claims.

Reference will now be made in detail to the subject matter disclosed, which is illustrated in the accompanying drawings.

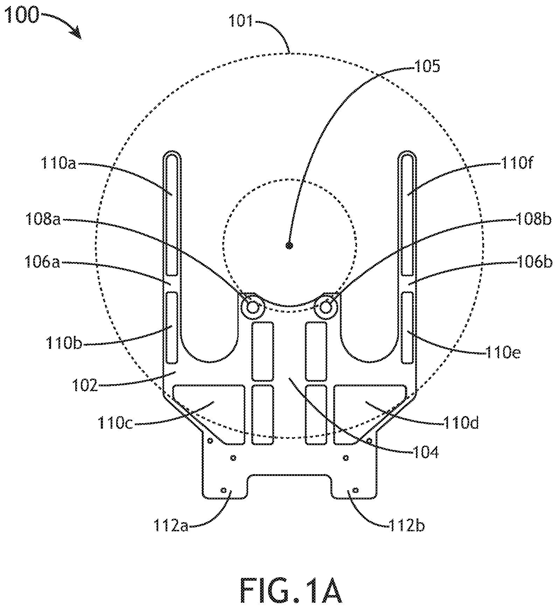

Referring generally to FIGS. 1A-4, systems and methods for handling substrates are described, in accordance with one or more embodiments of the present disclosure.

Embodiments of the present disclosure are directed to a substrate handling apparatus configured to handle a wide variety of substrate shapes and sizes, including warped substrates. Additional embodiments of the present disclosure are directed to a substrate handling apparatus including a forked structure, a first active support element, and a second active support element. It is noted herein that the substrate handling apparatus of the present disclosure may be able to safely and efficiently handle substrates of various shapes and sizes, thereby reducing contamination and increasing throughput.

FIG. 1A illustrates a top view of a substrate handling apparatus 100, in accordance with one or more embodiments of the present disclosure. In one embodiment, the substrate handling apparatus 100 includes a forked structure 102. The forked structure 102 may include, but is not limited to, a base 104, one or more support portions, one or more active support elements, one or more passive support elements, and one or more attachment structures.

In one embodiment, the substrate handling apparatus 100 is configured to handle a substrate 101. Substrate handling apparatus 100 may be configured to receive a substrate 101 on the top surface of the substrate handling apparatus 100 in order to handle and/or transport the substrate 101. In this regard, a back surface of a substrate 101 may be placed on the top surface of the substrate handling apparatus (depicted in FIG. 1A) while in operation (e.g., while the substrate handling apparatus 100 is handling and/or transporting the substrate 101). Accordingly, it is noted herein that the broken lines of substrate 101 in FIG. 1A illustrate that the view is "seeing through" the substrate 101 in order to view substrate handling apparatus 100 beneath the substrate 101.

Substrate 101 may include any substrate known in the art including, but not limited to, a wafer, a mask, a reticle, a silicon wafer, a silicon carbide wafer, a composite material wafer, and the like. For example, substrate 101 may include a semiconductor wafer. For instance, substrate 101 may include a silicon wafer. As noted previously herein, substrate handling apparatus 100 may be configured to handle substrates 101 of various sizes, shapes, and/or thicknesses. For example, substrate handling apparatus 100 may be configured to handle a substrate 101 with a diameter of 300mm and a thickness of 200-1500 µm. In another example, substrate handling apparatus 100 may be configured to handle a substrate 101 with a warpage of 5mm. In yet another example, substrate handling apparatus 100 may be configured to handle a randomly warped substrate 101 with an uneven, random thickness.

Forked structure 102 may include a base 104. In one embodiment, base 104 includes one or more attachment structures configured to attach substrate handling apparatus 100 to a handling tool configured to move substrates 101 from one location to another including, but not limited to, a robot, an actuatable mechanical arm, or the like. For example, as depicted in FIG. 1A, substrate handling apparatus 100 may include a first attachment structure 112a and a second substrate attachment structure 112b coupled to the body 104. In this example, the first attachment structure 112a and the second attachment structure 112b may be mechanically coupled to a handling tool including, but not limited to, an articulable mechanical arm. Attachment structures may include any attachment structures known in the art to mechanically couple components including, but not limited to, interlocking components, hitches, nut/bolt assemblies, pin assemblies, and the like.

In another embodiment, forked structure 102 includes one or more support portions. In an embodiment, the one or more support portions may extend from the base 104 of the substrate handling apparatus 100. Support portions may include any support structures known in the art including, but not limited to, prongs, arms, support discs, support tabs, and the like. For example, forked structure 102 may include a first support portion 106a and a second support portion 106b. As depicted in FIG. 1A, support portions may resemble "arms" or "prongs." However, this is not to be regarded as a limitation on the present disclosure, unless noted otherwise herein. The invention defines a first elongated support portion and a second elongated support portion.

In another embodiment, substrate handling apparatus 100 includes one or more active support elements (the invention defines a first active support element and a second active support element). The one or more active support elements may include any support elements configured to actively support a substrate 101 known in the art including, but not limited to, one or more suction cups, one or more vacuum elements, one or more magnets, and the like. The active support elements may be disposed on the body 104 of the forked structure 102. In one embodiment, as illustrated in FIG. 1A, the one or more active support elements may be disposed on the forked structure 102 between the first support portion 106a and the second support portion 106b.

The one or more active support elements may be configured to couple to the back surface of the substrate 101 to provide for more stable and secure handling. For example, suction cups or other vacuum elements (active support elements 108) may utilize pressure differentials to couple the substrate handling apparatus 100 to the back surface of a substrate 101. Similarly, magnets may utilize magnetic fields to couple the substrate handling apparatus 100 to the back surface of a substrate 101.

As noted previously, the one or more active support elements may include suction cups, vacuum elements, magnets, and the like. For example, as depicted in FIG. 1A, forked structure 102 of substrate handling apparatus 100 includes a first vacuum suction cup (first active support element 108a) and a second vacuum suction cup (active support element 108b).

In another embodiment, the substrate handling apparatus 100 includes one or more passive support elements (the invention defines a plurality of passive support elements). For example, as depicted in FIG. 1A, substrate handling apparatus 100 may include a first passive support element 110a, a second passive support element 11 0b, a third passive support element 110c, a fourth passive support element 110d, a fifth passive support element 110e, and a sixth passive support element 11 0f. One or more passive support elements 110 may be arranged on the body 104 and the one or more support portions in any configuration. Therefore, the configuration depicted in FIG. 1A is provided solely for illustration, unless noted otherwise herein. By way of example, the substrate handling apparatus 100 may include a single continuous passive support element 110 which covers a portion, all, or substantially all of the top surface of the substrate handling apparatus 100.

The one or more passive support elements 110 may include any layers, coatings, support pads, or structures known in the art for contacting substrates 101 including, but not limited to, silicon coatings, silicon pads, electrostatic discharge (ESD) coatings, ESD pads, ESD mats, and the like. It is noted herein that substrates (substrate 101) may be damaged during handling and/or transportation by electrical contamination and/or arcing. In this regard, electrically insulating support pads or coatings (e.g., electrically insulating passive support elements 110) may serve to limit electrical contamination and arcing, thereby preventing and/or limiting damage to the substrate 101. In another embodiment, the one or more passive support elements 110 may be formed from any high-friction material, coating, or the like. High-friction materials may allow the one or more passive support elements 110 to prevent substrate 101 from sliding around within the substrate handling apparatus 100, thereby providing increased control and handling capabilities.

In one embodiment, the one or more active support elements (e.g., first active support element 108a and second active support element 108b) are positioned within the substrate handling apparatus 100 so as to couple to the substrate 101 at positions which are relatively close to the center of the substrate 101. It is notes herein that positions proximate to the center of substrate 101 may be less susceptible to some irregularities, such as warping. As such, embodiments which allow the one or more active support elements to couple to the substrate 101 at positions which are proximate to the center of substrate 101 may provide for improved handling with warped substrates.

In embodiments with a first active support element 108a and a second active support element 108b, it is noted herein that a substrate 101 will naturally "create" at least a third point of contact (e.g., passive point of contact) somewhere along the substrate handling apparatus 100 (e.g., forked structure 102, one or more support portions, one or more passive support elements, and the like). For example, as depicted in FIG. 1A, a substrate 101 placed on substrate handling apparatus 100 and coupled to the forked structure 102 via the first active support element 108a and the second active support element 108b will naturally "create" at least a third point of contact (a "passive point of contact") at some point along substrate handling apparatus 100, either due to the shape of the substrate 101 or due to the substrate 101 leaning, tilting, or the like. For instance, the substrate 101 may lean and create a passive point of contact along the first support portion 106a such that the substrate 101 is coupled to the substrate handling apparatus 100 at the first active support element 108a, the second active support element 108b, and the passive point of contact on first support portion 106a. In another example, a substrate 101 may be warped such that it creates a passive point of contact along the second support portion 106b. In this regard, the substrate 101 is coupled to the substrate handling apparatus 100 at the first active support element 108a, the second active support element 108b, and the passive point of contact on second support portion 106b.

In another embodiment, substrate handling apparatus 100 is configured to couple to a substrate 101 such that the center of gravity 105 of the substrate 101 is "in front of" the one or more active support elements, as illustrated in FIG. 1A. For example, the center of gravity 105 of the substrate 101 may be located in front of the first active support element 108a and the second active support element 108b, and may be located between the first support portion 106a and the second support portion 106b. By coupling to the substrate 101 such that the center of gravity 105 of the substrate 101 is in front of the one or more active support elements, it may be assured that the substrate 101 will lean, tilt, or otherwise form at least a third, passive point of contact at a point somewhere along the one or more support portions.

The natural creation of at least a third, passive point of contact may be distinguished from, and provide benefits over, previous 3X vacuum suction cup approaches described above. In a 3X vacuum suction cup approach, a substrate 101 may be coupled to a handling apparatus only at the three points which are defined by the pre-determined location of the three vacuum suction cups. Thus, in a 3X vacuum suction cup approach, the substrate handling apparatus couples to each substrate with a standard arrangement. This standard arrangement of the 3X vacuum suction cup approach may be ill-equipped to handle substrates of different sizes, shapes, and the like. Furthermore, the standard arrangement of the 3X vacuum suction cup approach may be ill-suited to handle warped substrates due to the irregular shape of the warped substrates. As such, the 3X vacuum suction cup approach may suffer from decreased handling and control abilities when handling warped substrates.

Comparatively, by naturally creating at least a third, passive point of contact, the substrate handling apparatus 100 of the present disclosure may provide for increased handling and control abilities with substrates of all shapes and sizes. Due to the fact that the substrate 101 coupled to the substrate handling apparatus 100 will naturally lean, tilt, or otherwise "create" at least a third, passive point of contact, each substrate 101 handled by the substrate handling apparatus 100 may have a unique handling arrangement (determined by the at least three points of contact), giving substrate handling apparatus 100 increased flexibility and utility over prior approaches. It is noted herein that substrate handling apparatus 100 may be able to handle substrates 101 of all shapes and sizes including, but not limited to, regular substrates, irregular substrates, warped convex substrates, warped concave substrates, warped saddle substrates (warped "potato chip" substrates), substrates with random local warp, and the like. With two points of contact via the first active support element 108a and the second active support element 108b, a substrate 101 will naturally and automatically lean or tilt to find at least a third, passive point of contact along the substrate handling apparatus 100. Thus, with substrate handling apparatus 100, a substrate 101 will automatically lay down onto at least a third point of contact no matter the shape of the substrate 101, the degree of warp, the direction of warp, the type of warp, or the like.

It is noted herein that the center of substrate 101 may be less susceptible to warping than are outer portions of the substrate 101. As such, portions of the substrate 101 near the center of the substrate 101 (e.g., center of gravity 105) may exhibit a lower warp metric (a metric indicative of the degree of warp) per unit distance as compared to outer portions of the substrate 101. Accordingly, in another embodiment, the one or more active support elements may be positioned in close proximity to the center of gravity 105 of the substrate (such that the center of gravity 105 is still "in front of" the active support elements) in order to minimize effects of warp on the one or more active support elements. Similarly, the one or more active support elements may be positioned in close proximity to one another in order to minimize warp between the one or more active support elements. For example, the first active support element 108a and the second active support element 108b may be positioned in close proximity to one another to minimize the amount of warp between the first active support element 108a and the second active support element 108b. By decreasing the amount of warp between the one or more active support elements, each of the one or more active support elements may be able to more effectively couple to the substrate 101, leading to increased handling and control.

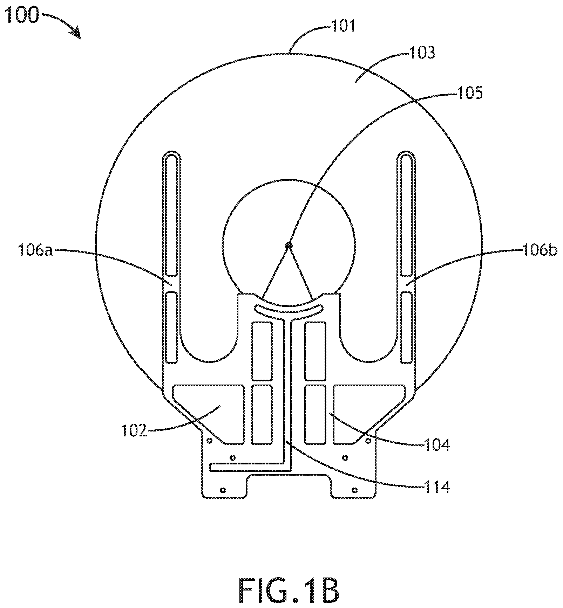

FIG. 1B illustrates a bottom view of a substrate handling apparatus 100, in accordance with one or more embodiments of the present disclosure. Substrate handling apparatus 100 may include, but is not limited to, the forked structure 102, the base 104, one or more support portions, and one or more vacuum channels 114. In one embodiment, substrate handling apparatus 100 is configured to pick up, handle, and/or carry a substrate 101. In this regard, substrate handling apparatus 100 may be configured to couple to the back surface 103 of substrate 101, as shown in FIG. 1B.

In another embodiment, the forked structure 102 of the substrate handling apparatus 100 includes one or more vacuum channels 114. The one or more vacuum channels 114 may be configured to fluidically couple the one or more active support elements (vacuum suction cups) to a vacuum source (not shown). The one or more vacuum channels 114 may include any channel known in the art including, but not limited to, one or more tubes, one or more pipes, one or more ducts, and the like. It is noted herein that the vacuum source (not shown) may constitute a component of substrate handling apparatus 100. Additionally, and/or alternatively, the vacuum source may constitute a separate or stand-alone vacuum source separate from substrate handling apparatus 100.

The one or more vacuum channels 114 may include any number or arrangement of vacuum channels known in the art, unless noted otherwise herein. For example, the one or more vacuum channels 114 may include a single, forked vacuum channel which fluidically couples the one or more active support elements to the vacuum source. By way of another example, the one or more vacuum channels 114 may include multiple separate vacuum channels. For instance, where substrate handling apparatus 100 includes a first active support element 108a and a second active support element 108b, the one or more vacuum channels 114 may include two separate vacuum channels 114 such that each active support element has a dedicated vacuum channel 114.

In another embodiment, the one or more vacuum channels 114 may exhibit symmetrical paths from the vacuum source to each of the one or more active support elements. It is noted herein that symmetrical paths of the one or more vacuum channels may cause the force generated by each of the one or more active support elements to be substantially equivalent. It is noted, however, that symmetrical paths from the vacuum source is not to be regarded as a limitation of the present disclosure, unless noted otherwise herein. Additionally, and/or alternatively, the one or more vacuum channels 114 and/or the one or more active support elements may be configured such that each of the one or more active support elements engage and couple to the back surface 103 of the substrate 101 at substantially the same time (e.g., "uniform" coupling).

In an alternative embodiment, the one or more vacuum channels 114 and/or one or more active support elements may be configured such that the one or more active support elements engage and couple to the substrate 101 at different times (e.g., "non-uniform" coupling). In non-uniform coupling embodiments, the first active support element coupled to the substrate 101 may serve to hold the substrate 101 in place such that subsequent active support elements may effectively couple to the substrate 101. For example, the first active support element 108a may include a shorter vacuum channel 114, and the second active support element 108b may include a longer vacuum channel 114. In this example, the first active support element 108a may engage and couple to the substrate 101 before the second active support element 108b. When the first active support element 108a couples to the back surface 103 of substrate 101, it may momentarily pull down and hold the substrate 101 such that the second active support element 108b may engage and effectively couple to the back surface 103 of substrate 101.

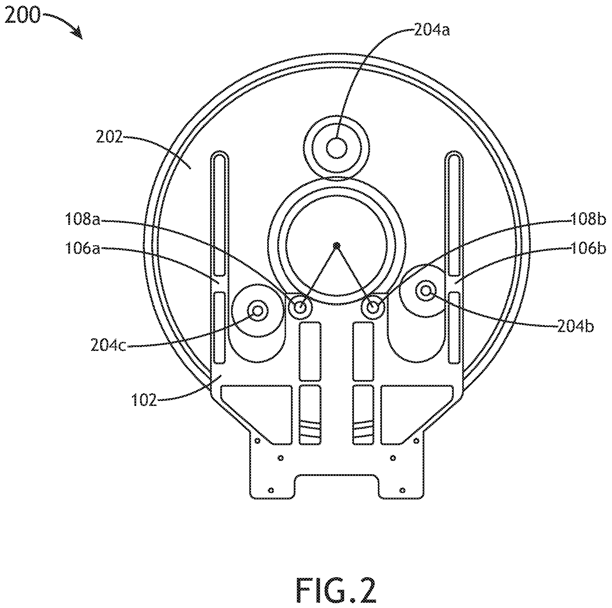

FIG. 2 illustrates a top view of a substrate handling system 200, in accordance with one or more embodiments of the present disclosure. The substrate handling system 200 may include, but is not limited to, substrate handling apparatus 100, a support structure 202, and one or more substrate contact points.

As depicted in FIG. 2, substrate handling apparatus 100 may be configured to handle a substrate 101 and to place the substrate 101 on one or more substrate contact points 204a, 104b, 204c of a support structure 202. The support structure 202 may include any substrate support structure 202 known in the art. For example, the support structure 202 may include a chuck of a process tool or characterization tool. In another example, the support structure 202 may include a support structure of a substrate transportation device (e.g., wafer transportation device). For instance, the support structure 202 may include a support structure of a front opening unified pod (FOUP). By way of another example, the support structure 202 may include a pre-aligner. The one or more substrate contact points may include any structures configured to receive a substrate 101 including, but not limited to, one or more active support elements, one or more passive support elements, one or more electrically insulating structures, and the like.

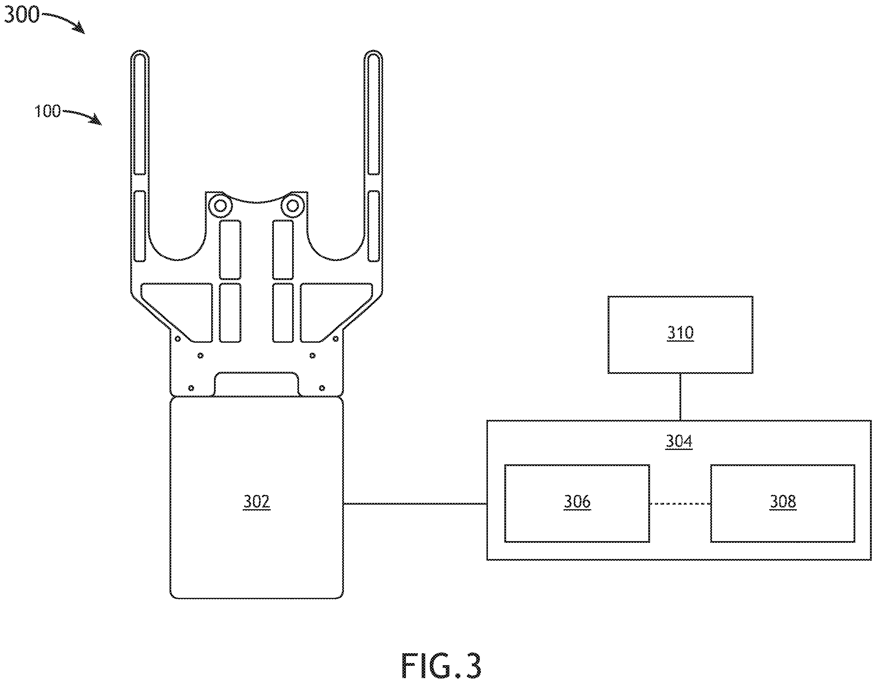

FIG. 3 illustrates a simplified schematic view of a substrate handling system 300, in accordance with one or more embodiments of the present disclosure. The substrate handling system 300 may include, but is not limited to, substrate handling apparatus 100, a handling tool 302, a controller 304, and a user interface 310.

In one embodiment, the substrate handling apparatus 100 may be mechanically coupled to a handling tool 302. Handling tool 302 may include any handling tool known in the art including, but not limited to, a robot, an actuatable mechanical arm, and the like. In another embodiment, the substrate handling apparatus 100 and/or the handling tool 302 are communicatively coupled to a controller 304. The controller 304 may include one or more processors 306 and memory 308. In one embodiment, the one or more processors 306 of controller 304 are configured to execute a set of program instructions stored in memory 308, the program instructions configured to cause the one or more processors 306 to carry out one or more of the steps/actions of the present disclosure. For example, the one or more processors 306 may be configured to actuate the handling tool 302. By way of another example, the one or more processors 306 may be configured to engage the one or more active support elements (e.g., activate vacuum source) in order to couple the substrate handling apparatus 100 to a substrate in order to pick up the substrate 101. By way of another example, the one or more processors 306 may be configured to dis-engage the one or more active support elements (e.g., deactivate vacuum source) in order to decouple the substrate handling apparatus 100 from a substrate 101 and place the substrate 101 on a support structure 202.

In another embodiment, the controller 304 is communicatively coupled to a user interface 310. The user interface 310 may include any user interface known in the art configured to display information and/or receive inputs or commands from a user. Similarly, the one or more processors 306 may be configured to receive one or more inputs/commands from the user interface 310 and cause system 300 to perform one or more actions/steps in response to the one or more inputs/commands.

In one embodiment, the one or more processors 306 may include any one or more processing elements known in the art. In this sense, the one or more processors 306 may include any microprocessor-type device configured to execute software algorithms and/or instructions. In one embodiment, the one or more processors 306 may consist of a desktop computer, mainframe computer system, workstation, image computer, parallel processor, or other computer system (e.g., networked computer) configured to execute a program configured to operate the system 300, as described throughout the present disclosure. It should be recognized that the steps described throughout the present disclosure may be carried out by a single computer system or, alternatively, multiple computer systems. Furthermore, it should be recognized that the steps described throughout the present disclosure may be carried out on any one or more of the one or more processors 306. In general, the term "processor" may be broadly defined to encompass any device having one or more processing elements, which execute program instructions from memory 308. Moreover, different subsystems of the system 300 (e.g., substrate handling apparatus 100, vacuum source, handling tool 302, controller 304) may include processor or logic elements suitable for carrying out at least a portion of the steps described throughout the present disclosure. Therefore, the above description should not be interpreted as a limitation on the present disclosure but merely an illustration.

The memory 308 may include any storage medium known in the art suitable for storing program instructions executable by the associated one or more processors 306. For example, the memory 308 may include a non-transitory memory medium. For instance, the memory 308 may include, but is not limited to, a read-only memory (ROM), a random access memory (RAM), a magnetic or optical memory device (e.g., disk), a magnetic tape, a solid state drive, and the like. It is further noted that memory 308 may be housed in a common controller housing with the one or more processors 306. In an alternative embodiment, the memory 308 may be located remotely with respect to the physical location of the processors 306 and controller 304. In another embodiment, the memory 308 maintains program instructions for causing the one or more processors 306 to carry out the various steps described through the present disclosure.

In one embodiment, the user interface 310 may include, but is not limited to, one or more desktops, tablets, smartphones, smart watches, or the like. In another embodiment, the user interface 310 includes a display used to display data of the system 300 to a user. The display of the user interface 310 may include any display known in the art. For example, the display may include, but is not limited to, a liquid crystal display (LCD), an organic light-emitting diode (OLED) based display, or a CRT display. Those skilled in the art should recognize that any display device capable of integration with a user interface 310 is suitable for implementation in the present disclosure. In another embodiment, a user may input selections and/or instructions responsive to data displayed to the user via the user interface 310.

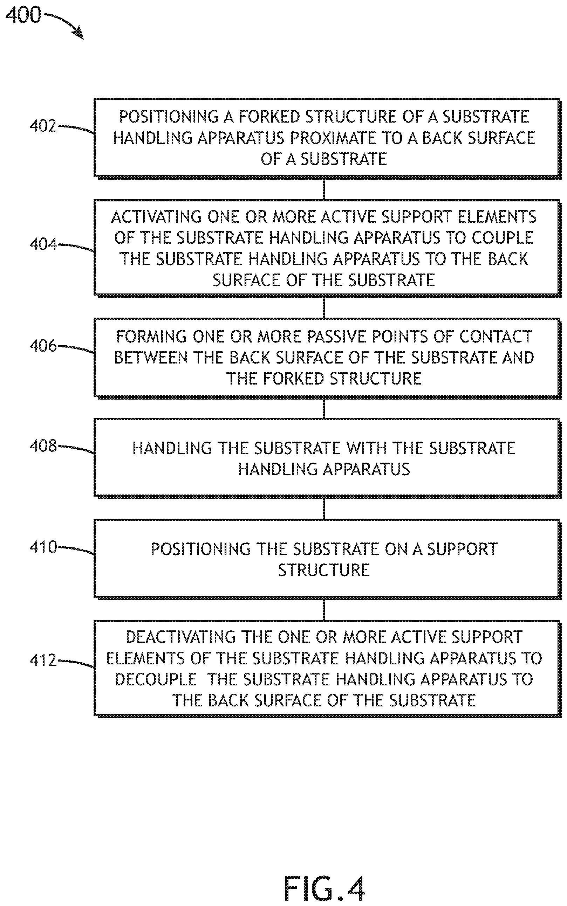

FIG. 4 illustrates a flowchart of a method 400 of handling a substrate, in accordance with one or more embodiments of the present disclosure. It is noted herein that the steps of method 400 may be implemented all or in part by substrate handling apparatus 100 and/or systems 200, 300. It is further recognized, however, that the method 400 is not limited to the substrate handling apparatus 100 and/or systems 200, 300, in that additional or alternative system-level embodiments may carry out all or part of the steps of method 400.

In a step 402, a forked structure of a substrate handling apparatus is positioned proximate to a back surface of a substrate. For example, substrate handling apparatus 100 with forked structure 102 may be positioned underneath a substrate 101, proximate to the back surface 103 of the substrate.

In a step 404, one or more active support elements of the substrate handling apparatus are activated to couple the substrate handling apparatus to the back surface of the substrate (the invention defines a first active support element and a second active support element). In one embodiment, the one or more active support elements include one or more vacuum suction cups. For example, in the step 404, a vacuum source may be activated in order to activate/engage the one or more vacuum suction cups (e.g., one or more active support elements 108). Upon activation of the vacuum source, the one or more active support elements may couple to the back surface 103 of the substrate. As noted previously herein, the one or more active support elements may be configured to couple to the back surface 103 of the substrate 101 at substantially the same time (e.g., a uniform coupling configuration) or at different times (e.g., non-uniform coupling configuration).

In a step 406, one or more passive points of contact are formed between the back surface of the substrate and the forked structure. For example, when a substrate is placed on the substrate handling apparatus 100 and coupled to the first active support element 108a and the second active support element 108b, the substrate may naturally/automatically lean or tilt to form at least a third, passive point of contact between the back surface 103 of the substrate 101 and the forked structure 102. As noted previously herein, the creation of one or more passive points of contact may allow the substrate handling apparatus 100 of the present disclosure to handle substrates 101 with varying shapes and irregularities including, but not limited to, regular substrates, irregular substrates, warped convex substrates, warped concave substrates, warped saddle substrates, substrates with random local warp, and the like.

In a step 408, the substrate is handled with the substrate handling apparatus. For example, the substrate handling apparatus 100 may be coupled to an actuatable mechanical arm (e.g., handling tool 302) which is configured to transport the substrate from one location to another.

In a step 410, the substrate is positioned on a support structure. The support structure 202 may include any substrate support structure 202 known in the art including, but not limited to, a chuck of a process tool or characterization tool, a substrate transportation device, a wafer transportation device, a support structure of a front opening unified pod (FOUP), and the like.

In a step 412, the one or more active support elements of the substrate handling apparatus are deactivated to decouple the substrate handling apparatus from the back surface of the substrate. For example, the vacuum source may be deactivated, which may cause the one or more vacuum suction cups (e.g., one or more active support elements) to deactivate/disengage and decouple form the back surface 103 of the substrate 101. After the one or more active support elements are decoupled from the substrate, the substrate handling apparatus 100 may be moved away from the back surface 103 of the substrate 101. For example, after placing the substrate on a support structure 202 (e.g., a chuck), the one or more active support elements may decouple from the substrate 101, and a handling tool 302 (e.g., an actuatable mechanical arm) may pull the forked structure out from beneath the substrate 101.

One skilled in the art will recognize that the herein described components (e.g., operations), devices, objects, and the discussion accompanying them are used as examples for the sake of conceptual clarity and that various configuration modifications are contemplated. Consequently, as used herein, the specific exemplars set forth and the accompanying discussion are intended to be representative of their more general classes. In general, use of any specific exemplar is intended to be representative of its class, and the non-inclusion of specific components (e.g., operations), devices, and objects should not be taken as limiting. The scope of the invention is defined by the appended claims.

The previous description is presented to enable one of ordinary skill in the art to make and use the invention as provided in the context of a particular application and its requirements. As used herein, directional terms such as "top," "bottom," "over," "under," "upper," "upward," "lower," "down," and "downward" are intended to provide relative positions for purposes of description, and are not intended to designate an absolute frame of reference. Various modifications to the described embodiments will be apparent to those with skill in the art, and the general principles defined herein may be applied to other embodiments. The scope of the present invention is defined by the appended claims.

All of the methods described herein may include storing results of one or more steps of the method embodiments in memory. The results may include any of the results described herein and may be stored in any manner known in the art. The memory may include any memory described herein or any other suitable storage medium known in the art. After the results have been stored, the results can be accessed in the memory and used by any of the method or system embodiments described herein, formatted for display to a user, used by another software module, method, or system, and the like. Furthermore, the results may be stored "permanently," "semi-permanently," temporarily," or for some period of time. For example, the memory may be random access memory (RAM), and the results may not necessarily persist indefinitely in the memory.

It is further contemplated that each of the embodiments of the method described above may include any other step(s) of any other method(s) described herein. In addition, each of the embodiments of the method described above may be performed by any of the systems described herein.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically mateable and/or physically interacting components and/or wirelessly interactable and/or wirelessly interacting components and/or logically interacting and/or logically interactable components.

The invention is defined by the appended claims which have to be understood according to the EPC.

## Claims

1. A substrate handling apparatus (100) comprising:
a forked structure (102) including a first elongated support portion (106a) and a second elongated support portion (106b), wherein the first elongated support portion and the second elongated support portion are arranged to provide access to a back surface of a substrate (101) for placement of the substrate on a support structure;
a first active support element (108a) and a second active support element (108b) disposed on the forked structure (102), the first active support element (108a) and the second active support (108b) element disposed between the first elongated support portion (106a) and the second elongated support portion (106b) of the forked structure (102), the first active support element (108a) configured to establish a first, active point of contact on the substrate and the second active support element (108b) configured to establish a second, active point of contact on the substrate; and
a plurality of passive support elements (110a, 110b) disposed on the forked structure (102), wherein a first passive support element (110a) runs along a length of the first elongated support portion (106a) and a second passive support element (110b) runs along a length of the second elongated support portion (106b), wherein the first active support element (108a) and the second active support element (108b) are configured such that a center of gravity of the substrate is positioned in front of the first active support element (108a) and the second active support element (108b) such as to define a third, passive point of contact of the substrate, wherein the first active support element (108a) and the second active support element (108b) do not overlap with the one or more of the plurality of passive support elements (110a, 110b).

2. The apparatus of claim 1, wherein the first active support element (108a) and the second active support element (108b) are configured to cause contact between the substrate and a portion of the plurality of passive support elements (110a, 110b) when the substrate is placed on the first active support element (108a) and the second active support element (108b).

3. The apparatus of claim 1, wherein the first active support element (108a) comprises a first suction element and the second active support element (108b) comprises a second suction element.

4. The apparatus of claim 3, wherein the first suction element and the second suction element are fluidically coupled to a vacuum through one or more vacuum channels (114) of the forked structure (102).

5. The apparatus of claim 1,
wherein the plurality of passive support elements (110a, 110b) comprise a plurality of support pads; or
wherein the plurality of passive support elements (110a, 110b) comprise a plurality of support pads; and wherein at least some of the plurality of support pads are textured; or
wherein the plurality of passive support elements (110a, 110b) comprise a plurality of support pads; and wherein at least some of the plurality of support pads are electrically insulating.

6. The apparatus of claim 1, wherein the plurality of passive support elements (110a, 110b) comprise:
one or more first support pads disposed on the first elongated support portion (106a) of the forked structure (102); and
one or more second support pads disposed on the second elongated support portion (106b) of the forked structure (102).

7. The apparatus of claim 6, wherein the plurality of passive support elements (110a, 110b) further comprise:
one or more additional support pads disposed on an additional support portion of the forked structure (102), wherein the additional support section forms a base of the forked structure.

8. The apparatus of claim 1, wherein forked structure (102) is mechanically coupled to an actuatable mechanical arm.

9. A system (200) comprising:
a chuck (202); and
a substrate handing apparatus (100) as recited in any previous claim.

10. The system of claim 9,
wherein the first active support element (108a) and the second active support element (108b) are configured to cause contact between the substrate and a portion of the plurality of passive support elements (110a, 110b) when the substrate is placed on the first active support element (108a) and the second active support element (108b); or
wherein the first active support element (108a) comprises a first suction element and the second active support element (108b) comprises a second suction element; or
wherein the first suction element and the second suction element are fluidically coupled to a vacuum through one or more channels of the forked structure (102).

11. The system of claim 9,
wherein the plurality of passive support elements (110a, 110b) comprise a plurality of support pads; or
wherein the plurality of passive support elements (110a, 110b) comprise a plurality of support pads; and wherein at least some of the plurality of support pads are textured; or
wherein the plurality of passive support elements (110a, 110b) comprise a plurality of support pads; and wherein at least some of the plurality of support pads are electrically insulating.

12. The system of claim 9, wherein the plurality of passive support elements (110a, 110b) comprise:
one or more first support pads disposed on the first support portion of the forked structure; and
one or more second support pads disposed on the second support portion of the forked structure; or
wherein the plurality of passive support elements comprise:
one or more first support pads disposed on the first support portion of the forked structure; and
one or more second support pads disposed on the second support portion of the forked structure; and
wherein the plurality of passive support elements further comprise:
one or more additional support pads disposed on an additional support portion of the forked structure, wherein the additional support section forms the base of the forked structure.

## Patentansprüche

1. Vorrichtung (100) zur Handhabung von Substraten, umfassend:
eine Gabelstruktur (102), die einen ersten langgestreckten Stützabschnitt (106a) und einen zweiten langgestreckten Stützabschnitt (106b) beinhaltet, wobei der erste langgestreckte Stützabschnitt und der zweite langgestreckte Stützabschnitt so angeordnet sind, dass sie Zugang zu einer hinteren Fläche eines Substrats (101) zur Platzierung des Substrats auf einer Stützstruktur bereitstellen;
ein erstes aktives Stützelement (108a) und ein zweites aktives Stützelement (108b), die an der Gabelstruktur (102) angeordnet sind, wobei das erste aktive Stützelement (108a) und das zweite aktive Stützelement (108b) zwischen dem ersten langgestreckten Stützabschnitt (106a) und dem zweiten langgestreckten Stützabschnitt (106b) der Gabelstruktur (102) angeordnet sind, wobei das erste aktive Stützelement (108a) dazu konfiguriert ist, einen ersten, aktiven Kontaktpunkt auf dem Substrat herzustellen, und das zweite aktive Stützelement (108b) dazu konfiguriert ist, einen zweiten, aktiven Kontaktpunkt auf dem Substrat herzustellen; und
eine Vielzahl von passiven Stützelementen (110a, 110b), die auf der Gabelstruktur (102) angeordnet ist,
wobei ein erstes passives Stützelement (110a) entlang einer Länge des ersten langgestreckten Stützabschnitts (106a) verläuft und ein zweites passives Stützelement (110b) entlang einer Länge des zweiten langgestreckten Stützabschnitts (106b) verläuft, wobei das erste aktive Stützelement (108a) und das zweite aktive Stützelement (108b) derart konfiguriert sind, dass ein Schwerpunkt des Substrats vor dem ersten aktiven Stützelement (108a) und dem zweiten aktiven Stützelement (108b) positioniert ist, um einen dritten passiven Kontaktpunkt des Substrats zu definieren, wobei das erste aktive Stützelement (108a) und das zweite aktive Stützelement (108b) sich nicht mit dem einen oder den mehreren der Vielzahl von passiven Stützelementen (110a, 110b) überlappen.

2. Vorrichtung nach Anspruch 1, wobei das erste aktive Stützelement (108a) und das zweite aktive Stützelement (108b) dazu konfiguriert sind, einen Kontakt zwischen dem Substrat und einem Abschnitt der Vielzahl von passiven Stützelementen (110a, 110b) zu bewirken, wenn das Substrat auf dem ersten aktiven Stützelement (108a) und dem zweiten aktiven Stützelement (108b) platziert wird.

3. Vorrichtung nach Anspruch 1, wobei das erste aktive Stützelement (108a) ein erstes Saugelement umfasst und das zweite aktive Stützelement (108b) ein zweites Saugelement umfasst.

4. Vorrichtung nach Anspruch 3, wobei das erste Saugelement und das zweite Saugelement durch einen oder mehrere Vakuumkanäle (114) der Gabelstruktur (102) fluidisch mit einem Vakuum gekoppelt sind.

5. Vorrichtung nach Anspruch 1,
wobei die Vielzahl von passiven Stützelementen (110a, 110b) eine Vielzahl von Stützkissen umfasst; oder
wobei die Vielzahl von passiven Stützelementen (110a, 110b) eine Vielzahl von Stützkissen umfasst; und wobei zumindest einige der Vielzahl von Stützkissen strukturiert sind; oder
wobei die Vielzahl von passiven Stützelementen (110a, 110b) eine Vielzahl von Stützkissen umfasst; und wobei zumindest einige der Vielzahl von Stützkissen elektrisch isolierend sind.

6. Vorrichtung nach Anspruch 1, wobei die Vielzahl von passiven Stützelementen (110a, 110b) Folgendes umfasst:
ein oder mehrere erste Stützkissen, die auf dem ersten langgestreckten Stützabschnitt (106a) der Gabelstruktur (102) angeordnet sind; und
ein oder mehrere zweite Stützkissen, die auf dem zweiten langgestreckten Stützabschnitt (106b) der Gabelstruktur (102) angeordnet sind.

7. Vorrichtung nach Anspruch 6, wobei die Vielzahl von passiven Stützelementen (110a, 110b) ferner Folgendes umfasst:
ein oder mehrere zusätzliche Stützkissen, die auf einem zusätzlichen Stützabschnitt der Gabelstruktur (102) angeordnet sind, wobei der zusätzliche Stützabschnitt eine Basis der Gabelstruktur bildet.

8. Vorrichtung nach Anspruch 1, wobei die Gabelstruktur (102) mechanisch mit einem betätigbaren mechanischen Arm gekoppelt ist.

9. System (200), umfassend:
ein Spannfutter (202); und
eine Vorrichtung (100) zur Handhabung von Substraten nach einem der vorhergehenden Ansprüche.

10. System nach Anspruch 9,
wobei das erste aktive Stützelement (108a) und das zweite aktive Stützelement (108b) dazu konfiguriert sind, einen Kontakt zwischen dem Substrat und einem Abschnitt der Vielzahl von passiven Stützelementen (110a, 110b) zu bewirken, wenn das Substrat auf dem ersten aktiven Stützelement (108a) und dem zweiten aktiven Stützelement (108b) platziert wird; oder
wobei das erste aktive Stützelement (108a) ein erstes Saugelement umfasst und das zweite aktive Stützelement (108b) ein zweites Saugelement umfasst; oder
wobei das erste Saugelement und das zweite Saugelement durch einen oder mehrere Kanäle der Gabelstruktur (102) fluidisch mit einem Vakuum gekoppelt sind.

11. System nach Anspruch 9,
wobei die Vielzahl von passiven Stützelementen (110a, 110b) eine Vielzahl von Stützkissen umfasst; oder
wobei die Vielzahl von passiven Stützelementen (110a, 110b) eine Vielzahl von Stützkissen umfasst; und wobei zumindest einige der Vielzahl von Stützkissen strukturiert sind; oder
wobei die Vielzahl von passiven Stützelementen (110a, 110b) eine Vielzahl von Stützkissen umfasst; und wobei zumindest einige der Vielzahl von Stützkissen elektrisch isolierend sind.

12. System nach Anspruch 9, wobei die Vielzahl von passiven Stützelementen (110a, 110b) Folgendes umfasst:
ein oder mehrere erste Stützkissen, die auf dem ersten Stützabschnitt der Gabelstruktur angeordnet sind; und
ein oder mehrere zweite Stützkissen, die auf dem zweiten Stützabschnitt der Gabelstruktur angeordnet sind; oder
wobei die Vielzahl von passiven Stützelementen Folgendes umfasst:
ein oder mehrere erste Stützkissen, die auf dem ersten Stützabschnitt der Gabelstruktur angeordnet sind; und
ein oder mehrere zweite Stützkissen, die auf dem zweiten Stützabschnitt der Gabelstruktur angeordnet sind; und
wobei die Vielzahl von passiven Stützelementen ferner Folgendes umfasst:
ein oder mehrere zusätzliche Stützkissen, die auf einem zusätzlichen Stützabschnitt der Gabelstruktur angeordnet sind, wobei der zusätzliche Stützabschnitt die Basis der Gabelstruktur bildet.

## Revendications

1. Appareil de manipulation de substrat (100) comprenant :
une structure fourchue (102) comportant une première partie de support allongée (106a) et une seconde partie de support allongée (106b), dans lequel la première partie de support allongée et la seconde partie de support allongée sont agencées pour fournir un accès à une surface arrière d'un substrat (101) pour le placement du substrat sur une structure de support ;
un premier élément de support actif (108a) et un second élément de support actif (108b) disposés sur la structure fourchue (102), le premier élément de support actif (108a) et le second élément de support actif (108b) étant disposés entre la première partie de support allongée (106a) et la seconde partie de support allongée (106b) de la structure fourchue (102), le premier élément de support actif (108a) étant configuré pour établir un premier point de contact actif sur le substrat et le second élément de support actif (108b) étant configuré pour établir un deuxième point de contact actif sur le substrat ; et
une pluralité d'éléments de support passifs (110a, 110b) disposés sur la structure fourchue (102),
dans lequel un premier élément de support passif (110a) s'étend sur une longueur de la première partie de support allongée (106a) et un second élément de support passif (110b) s'étend sur une longueur de la seconde partie de support allongée (106b), dans lequel le premier élément de support actif (108a) et le second élément de support actif (108b) sont configurés de sorte qu'un centre de gravité du substrat est positionné devant le premier élément de support actif (108a) et le second élément de support actif (108b) de manière à définir un troisième point de contact passif du substrat, dans lequel le premier élément de support actif (108a) et le second élément de support actif (108b) ne chevauchent pas les un ou plusieurs de la pluralité d'éléments de support passifs (110a, 110b).

2. Appareil selon la revendication 1, dans lequel le premier élément de support actif (108a) et le second élément de support actif (108b) sont configurés pour provoquer un contact entre le substrat et une partie de la pluralité d'éléments de support passifs (110a, 110b) lorsque le substrat est placé sur le premier élément de support actif (108a) et le second élément de support actif (108b).

3. Appareil selon la revendication 1, dans lequel le premier élément de support actif (108a) comprend un premier élément d'aspiration et le second élément de support actif (108b) comprend un second élément d'aspiration.

4. Appareil selon la revendication 3, dans lequel le premier élément d'aspiration et le second élément d'aspiration sont couplés fluidiquement à un vide à travers un ou plusieurs canaux de vide (114) de la structure fourchue (102).

5. Appareil selon la revendication 1,
dans lequel la pluralité d'éléments de support passifs (110a, 110b) comprennent une pluralité de coussinets de support ; ou
dans lequel la pluralité d'éléments de support passifs (110a, 110b) comprennent une pluralité de coussinets de support ; et
dans lequel au moins certains de la pluralité de coussinets de support sont texturés ; ou
dans lequel la pluralité d'éléments de support passifs (110a, 110b) comprennent une pluralité de coussinets de support ; et
dans lequel au moins certains de la pluralité de coussinets de support sont électriquement isolants.

6. Appareil selon la revendication 1, dans lequel la pluralité d'éléments de support passifs (110a, 110b) comprennent :
un ou plusieurs premiers coussinets de support disposés sur la première partie de support allongée (106a) de la structure fourchue (102) ; et
un ou plusieurs seconds coussinets de support disposés sur la seconde partie de support allongée (106b) de la structure fourchue (102).

7. Appareil selon la revendication 6, dans lequel la pluralité d'éléments de support passifs (110a, 110b) comprennent en outre :
un ou plusieurs coussinets de support supplémentaires disposés sur une partie de support supplémentaire de la structure fourchue (102), dans lequel la section de support supplémentaire forme une base de la structure fourchue.

8. Appareil selon la revendication 1, dans lequel la structure fourchue (102) est couplée mécaniquement à un bras mécanique actionnable.

9. Système (200) comprenant :
un mandrin (202) ; et
un appareil de manipulation de substrat (100) selon une quelconque revendication précédente.

10. Système selon la revendication 9,
dans lequel le premier élément de support actif (108a) et le second élément de support actif (108b) sont configurés pour provoquer un contact entre le substrat et une partie de la pluralité d'éléments de support passifs (110a, 110b) lorsque le substrat est placé sur le premier élément de support actif (108a) et le second élément de support actif (108b) ; ou
dans lequel le premier élément de support actif (108a) comprend un premier élément d'aspiration et le second élément de support actif (108b) comprend un second élément d'aspiration ; ou
dans lequel le premier élément d'aspiration et le second élément d'aspiration sont couplés fluidiquement à un vide à travers un ou plusieurs canaux de la structure fourchue (102).

11. Système selon la revendication 9,
dans lequel la pluralité d'éléments de support passifs (110a, 110b) comprennent une pluralité de coussinets de support ; ou
dans lequel la pluralité d'éléments de support passifs (110a, 110b) comprennent une pluralité de coussinets de support ; et
dans lequel au moins certains de la pluralité de coussinets de support sont texturés ; ou
dans lequel la pluralité d'éléments de support passifs (110a, 110b) comprennent une pluralité de coussinets de support ; et
dans lequel au moins certains de la pluralité de coussinets de support sont électriquement isolants.

12. Système selon la revendication 9, dans lequel la pluralité d'éléments de support passifs (110a, 110b) comprennent :
un ou plusieurs premiers coussinets de support disposés sur la première partie de support de la structure fourchue ; et
un ou plusieurs seconds coussinets de support disposés sur la seconde partie de support de la structure fourchue ; ou
dans lequel la pluralité d'éléments de support passifs comprennent :
un ou plusieurs premiers coussinets de support disposés sur la première partie de support de la structure fourchue ; et
un ou plusieurs seconds coussinets de support disposés sur la seconde partie de support de la structure fourchue ; et
dans lequel la pluralité d'éléments de support passifs comprennent en outre :
un ou plusieurs coussinets de support supplémentaires disposés sur une partie de support supplémentaire de la structure fourchue, dans lequel la section de support supplémentaire forme la base de la structure fourchue.
